# EUROPÄISCHE PATENTSCHRIFT

(11) **EP 2 342 961 B1**
(45) Veröffentlichungstag und Bekanntmachung des Hinweises auf die Patenterteilung: **30.09.2015**
(21) Anmeldenummer: 09745030.8
(22) Anmeldetag: 29.10.2009
(51) Int. Cl.: H05K 7/20

(54) **KLIMATISIERUNGSVORRICHTUNG FÜR SCHALTSCHRÄNKE**
AIR-CONDITIONING DEVICE FOR CONTROL CABINETS
DISPOSITIF DE CLIMATISATION POUR ARMOIRES DE COMMUTATION

(30) Priorität: 31.10.2008 DE 102008054081
(43) Veröffentlichungstag der Anmeldung: 13.07.2011
(73) Patentinhaber: Seifert Mtm Systems Malta Ltd., Malta 06 (MT)
(72) Erfinder: SEIFERT, Michael Rudi, Madliena (MT); ZAMMIT, Keith Patrick, Safi (MT); HIRTH, Leo, Gharghur (MT)
(74) Vertreter: Meissner, Bolte & Partner GbR
(86) Internationale Anmeldenummer: PCT/EP2009/064275
(87) Internationale Veröffentlichungsnummer: WO 2010/049482

(56) Entgegenhaltungen:
- EP-A1- 1 367 331
- WO-A2-2008/128311
- GB-A- 2 300 910
- US-A1- 2004 007 348
- US-A1- 2007 227 168
- US-B1- 6 330 152

## Beschreibung

Die Erfindung betrifft eine Klimatisierungsvorrichtung für Schaltschränke, wobei die in einem Gehäuse platzierte Klimatisierungsvorrichtung in baulicher Nähe zu einem Schaltschrank angebracht ist und mittels zum Schaltschrank weisenden Öffnungen eine Luftzirkulation zwischen dem Schrank und der Klimatisierungsvorrichtung ermöglicht wird, gemäß Oberbegriff des Anspruchs 1.

Aus dem Stand der Technik sind eine Vielzahl von Klimaanlagen und -geräten bekannt, wobei die Kühlung auf Grund unterschiedlicher physikalischer Prinzipien erfolgt und zusätzlich verschiedene Klimaanlagen-Steuerungssysteme dargelegt werden.

Die Gebrauchsmusterschrift DE 201 05 487 U1 offenbart ein Kühlgerät, welches in mehreren Modi, zur Optimierung der Effektivität betrieben werden kann. Die Klimatisierung von Räumen und insbesondere von Schaltschränken erfolgt auf Basis von Peltier-Elementen, wobei das Kühlgerät aus jeweils einem zwangsbelüfteten Wärmetauscher auf der Innen- und der Außenseite des zu klimatisierenden Raumes und dazwischen angebrachten Peltier-Elementen besteht. Das Kühlgerät kann in drei unterschiedlichen Kühlmodi betrieben werden, wobei für jeden einzelnen Modus die Verschaltung der Peltier-Elemente untereinander geändert wird, und das Kühlgerät mit mindestens vier jeweils einzeln verschaltbaren Peltier-Einheiten bestückt ist, und die Umschaltung zwischen den einzelnen Kühlmodi in Abhängigkeit von der Umgebungstemperatur vorgenommen wird.

Eine Vielzahl von bekannten Klimaanlagen für Schaltschränke wird auf Basis einer Kompressorkühlung betrieben. Die Steuerung des Kompressors erfolgt dabei entweder temperaturabhängig oder temperatur- und zeitabhängig, wobei der Kompressor beim Erreichen festgelegter Temperaturwerte aus- und eingeschaltet wird. Bei der Kombination mit einer zeitabhängigen Steuerung erfolgt der Ein- und Ausschaltvorgang des Kompressors in Abhängigkeit der Temperaturwerte innerhalb des Schaltschrankes und zugleich nach Ablauf bestimmter Zeitintervalle. Dies hat zum einen höhere Schaltraten zur Folge, sodass der Kompressor noch häufiger als bei der reinen temperaturabhängigen Steuerung ausgeschaltet wird, führt jedoch zugleich zu höheren Temperaturschwankungen im Innenraum eines Schaltschrankes, da der Kompressor erst nach Ablauf eines Zeitintervalls auf geänderte Temperaturzustände reagieren kann. Dies führt zu einem übermäßig hohen Ansteigen bzw. Fallen der Gehäuseinnenraumtemperaturen. Zugleich wird der Kompressor bei einer derartigen Steuerung dermaßen häufig ein- und ausgeschaltet, dass dies aufgrund der ständigen Rotationskräfte zu einer Verringerung der Lebensdauer des Kompressors und der mit dem Kompressor in Verbindung stehenden Schlauchsysteme führt. Die durchschnittliche Betriebsdauer eines Kompressors von ca. zehn Jahren wird bei häufigem Ein- und Ausschalten und Betrieb des Kompressors auf Höchststufe auf zwei Jahre dezimiert.

In der DE 692 23 460 T2 wird eine Betriebssteuerungseinheit für Klimageräte beschrieben, welche einen Kompressor aufweisen, der intermittierend betrieben werden kann und eine variable Betriebsfrequenz hat. Die Betriebssteuerung ist dabei derart eingestellt, dass eine vorgesehene Vorrichtung auf eine Differenz zwischen der Umgebungstemperatur und einer Einstelltemperatur reagiert, um die Betriebsfrequenz des Kompressors so zu steuern, dass die Temperaturdifferenz verringert wird und der Kompressor angehalten wird, wenn eine kleinere Klimatisierungslast als die Kapazität des Klimageräts bei einem Minimalwert der Betriebsfrequenz vorliegt.
Eine weitere Ausführungsform der Erfindung sieht einen Wechselrichter-getriebenen Kompressor und eine Steuervorrichtung vor, welche die minimale Betriebsfrequenz des Kompressors auf der Grundlage der Außenlufttemperatur ändert. Folglich kann ein kostengünstiger Betrieb bei derselben Kapazität erzielt werden.

Um ständig eine Klimatisierung mit dem höchsten Wirkungsgrad zu erzielen, weist eine dritte Ausführungsform eine Vorrichtung zur Berechnung des Betriebsverhältnisses eines Kompressors auf, die nicht nur zur Auswahl der Minimalfrequenz, sondern auch zur Korrektur der ausgewählten Minimalfrequenz dient, sodass das Betriebsverhältnis für die Minimalfrequenz optimiert werden kann. Folglich können nicht nur Minimalfrequenzen eingestellt werden, welche optimale Wirkungsgrade entsprechend verschiedenen Betriebsbedingungen zur Verfügung stellen, sondern es können auch Betriebsverhältnisse aufrechterhalten werden, welche für die jeweilige Betriebsfrequenz geeignet ist, um die Verschlechterung des Wirkungsgrades in Folge einer Verringerung des Betriebsverhältnisse zu verhindern.

Vor allem bei in Schaltschränken befindlichen elektrischen und elektronischen Bauteilen ist es bzgl. der Lebensdauer und der Ausfallquote der Bauteile von äußerster Wichtigkeit, dass diese einer konstanten Temperatur ausgesetzt werden. Schaltschränke können innerhalb und außerhalb von Gebäuden platziert sein. Schaltschränke von Mobilfunkanlagen sind beispielsweise auf Hausdächern montiert und sind dort jahreszeitabhängigen Temperaturschwankungen von - 20 °C bis + 50 °C ausgesetzt. Unabhängig dieser Temperaturen sollten die Bauteile in den Schaltschränken laut Herstellerangaben einer konstanten Temperatur ausgesetzt werden. Das Dokument EP1367331A1 offenbart eine Klimatisierungsvorrichtungen für Schaltschränke, die das Schaltschrankinnere erwärmen, aktiv mittels einer Kompressorkühlung oder passiv mittels Umluft kühlen kann und die ein batteriebasiertes Notstromsystem aufweist.
Aus den Dokumenten GB2300910A, US2007/227168A1, WO2008/128311 A2 und US6330152B1 sind weitere Klimatisierungsvorrichtungen für Schaltschränke bekannt, die in verschiedenen Modi betrieben werden können.
Das Dokument US2004/0007348A1 offenbart eine Klimatisierungsvorrichtung für einen Schaltschrank, bei der von Batterien gebildete Gase wie beispielsweise Wasserstoff über Lüftungsöffnungen abgeführt werden.

Es ist Aufgabe der vorliegenden Erfindung eine verbesserte Klimatisierungsvorrichtung für Schaltschränke anzugeben.

Die Lösung der Aufgabe erfolgt durch eine Klimatisierungsvorrichtung für Schaltschränke gemäss Anspruch 1, wobei die Unteransprüche mindestens zweckmäßige Ausgestaltungen und Weiterbildungen darstellen.

Es wird zunächst von einer Klimatisierungsvorrichtung für Schaltschränke ausgegangen, welche in einem Gehäuse platziert ist. Dieses befindet sich in baulicher Nähe zu einem Schaltschrank. Mittels zum Schaltschrank weisenden Öffnungen wird eine Luftzirkulation zwischen dem Schaltschrank und der Klimatisierungsvorrichtung ermöglicht.

Die Klimatisierungsvorrichtung kann in drei verschiedenen Arbeitsmodi betrieben werden. Es sind eine Aktivkühlung, eine Passivkühlung und eine Erwärmung der zirkulierenden Luft vorgesehen.

Die verschiedenen Arbeitsmodi werden je nach im Schaltschrank vorliegenden Temperaturen aktiviert. Hierzu wird zunächst ein Temperatursensor benötigt um auftretenden Temperaturunterschiede erkennen zu können. Liegen dabei, für die im Schaltschrank befindlichen elektrischen oder elektronischen Bauteile schädlich hohe Innenraumtemperaturen vor, wird der Modus Aktivkühlung aktiviert.

Die Aktivkühlung wird dabei durch eine bekannte Kompressorkühlung erreicht. Hierzu werden ein Kompressor, ein Kondensator und ein Verdampfer benötigt.

Die vom Schaltschrank erwärmte Luft gelangt durch eine Öffnung im oberen Bereich auf der zum Schaltschrank weisenden Seite des Gehäuses der Klimavorrichtung in das Gehäuse. Zugleich wird die zur Kompressorkühlung benötigte Kühlluft von einem wechselstromgespeistem Gebläse im unteren Bereich auf der von dem Schaltschrank abweisenden Seite durch eine Kühllufteinlassöffnung in das Gehäuse der Klimatisierungsvorrichtung transportiert.

Zweckmäßigerweise ist die Kühllufteinlassöffnung hierbei mit einem Metallmaschenfilter versehen, um in der Kühlluft enthaltene Staubpartikel zu Filtern.

Im Kompressor wird das gasförmige Kältemittel durch die Verdichtung zunächst sehr stark erhitzt. Das gasförmige Kältemittel wird zum Kondensator transportiert, wo die aufgenommene Kompressionswärme im Kondensator an die Umgebung abgegeben wird. Darüber hinaus wird zusätzlich die Energiewärme abgegeben, welche beim Kondensieren frei wird. Auf diese Weise verlässt das Kältemittel den Kondensator im flüssigen Aggregatszustand und wird in Richtung des Verdampfers transportiert. Die abgegebene Kompressionswärme und Energiewärme verlässt durch eine Öffnung oberhalb der Kühlluftöffnung das Klimatisierungsgehäuse.

Die vom Schaltschrank in das Gehäuse der Klimatisierungsvorrichtung transportierte Luft wird mittels eines gleichstromgespeisten Gebläses zum Verdampfer transportiert. Dort verdampft das vom Kondensator kommende flüssige Kältemittel unter den gegebenen Verhältnissen, wobei der Verdampfer der vom Schaltschrank kommenden Luft Wärme entzieht, und somit die Luft abkühlt.

Die abgekühlte Luft wird nach diesem Vorgang durch eine Öffnung auf der zum Schaltschrank weisenden Seite in den Schaltschrank transportiert. Dieser dargestellte Kreislauf wiederholt sich anschließend.

Erfindungsgemäß wird bei der dargelegten Kompressorkühlung ein drehzahlvariabler Kompressor verwendet. Dadurch muss der Kompressor nicht wie eingangs beschrieben immer wieder ein- und ausgeschaltet werden. Die Kompressorgeschwindigkeit wird in Abhängigkeit der Schaltschrankinnenraumtemperatur geregelt. Es werden unnötige Ein- und Ausschaltzyklen vermieden und die Betriebsdauer des Kompressors verlängert, zudem wird eine konstante Innenraumtemperatur des Schaltschrankes erzeugt. Ein Energieersparnis bei Kühlung eines Schaltschranks geht mit der Verwendung einer erfindungsgemäßen Klimatisierungsvorrichtung mit einem drehzahlvariablen Kompressor einher.

Eine weitere Ausführungsform der vorliegenden Erfindung sieht vor, dass es sich bei dem wechselstromgespeisten Gebläse, welches zum Transport der Kühlluft in das Gehäuse der Klimatisierungsvorrichtung verwendet wird, um ein drehzahlgeregeltes Gebläse handelt.

Das Gebläse wird dabei derart geregelt, sodass eine konstante Temperaturdifferenz zwischen der Umgebungstemperatur und der Kondensiertemperatur erreicht wird. Dies führt zu einem geringeren Stromverbrauch des Kompressors. Ein drehzahlgeregeltes Gebläse stellt neben der verringerten Lautstärke ein weiteres Energieeinsparpotential dar.

Liegen im Schaltschrank derartig niedrige Temperaturen vor, welche die elektrischen oder elektronischen Bauteile über längere Sicht schädigen würden, wird der Modus Erwärmung" aktiviert.

Bei diesem Modus wird die vom Schaltschrank an die Klimatisierungsvorrichtung abgegebene kalte Luft wiederum zum Bereich des Verdichters transportiert. Dort befindet sich ein wechselstromgespeistes Heizgerät, welches die kalte Luft erwärmt. Die Luftströmung wird, wie bereits beim Modus Aktivkühlung beschrieben, durch ein gleichstromgespeistes Gebläse erzeugt.

Die erwärmte Luft verlässt die Klimatisierungsvorrichtung durch die bereits aus dem Aktivkühlungs-Modus bekannte Öffnung auf der zum Schaltschrank weisenden Seite des Gehäuses.

Bei äußerst niedrigen Umgebungstemperaturen in Verbindung mit warmen Schaltschrankinnenraumtemperaturen oder bei Alarmzuständen im Schaltschrank besteht die Möglichkeit den Modus Passivkühlung zu aktivieren.

Bei der Aktivierung dieses Modus, wird eine im Gehäuse der Klimatisierungsvorrichtung erfindungsgemäß befindliche Drosselklappe aktiviert, sodass diese eine Stellung einnimmt, dass eine direkte Kühlung des Schaltschrankes mit der Umgebungsluft erreicht wird. Bei den Betriebsmodi Aktivkühlung und Erwärmung nimmt die Drosselklappe eine senkrechte Sperrstellung ein, sodass keine unbehandelte Umgebungsluft in die Klimatisierungsvorrichtung gelangen kann. Bei Ausführung des Modus Passivkühlung wird die Drosselklappe von einem gleichstrom- oder wechselstromgespeisten Motor angetrieben und in eine waagrechte Position gebracht.

In Folge dessen kann durch eine erste Öffnung im Gehäuse der Klimatisierungsvorrichtung, welche sich im obersten Bereich auf der vom Schaltschrank abgewandten Seite des Gehäuses befindet, die erwärmte, vom Schaltschrank abgegebenen Luft aus dem Gehäuseinneren transportiert werden und zugleich durch eine darunter befindliche zweite Öffnung kalte Umgebungsluft (Kühlluft) in das Klimatisierungsgehäuse transportiert werden.

Zweckmäßigerweise ist die zweite Öffnung mit einem plissierten HEPA (High Efficiency Particulate Airfilter)-Filter versehen um Staubpartikel aus der Umgebungsluft zu filtern.

Die kühle Umgebungsluft wird mittels eines gleichstromgespeisten Gebläses in Richtung des Verdampfers transportiert, wo sich die bekannte Kühlluftaustrittsöffnung befindet.

Der beschriebene Betriebsmodus stellt eine weitere Möglichkeit dar, den Kompressor so schonend bzw. so oft als möglich nicht benutzen zu müssen und dadurch Energie einzusparen.

Die erfindungsgemäße Klimatisierungsvorrichtung verfügt des Weiteren über ein Notstromsystem, welches vorzugsweise in Form von Batterien bereitgestellt wird.

In einer weiteren Ausführungsform sind alle oder einzelne Gebläse der Klimatisierungsvorrichtung als drehzahlgeregelte Gebläse ausgebildet.

Beim Start der Klimatisierungsvorrichtung bzw. der Kompressorkühlung ist vorgesehen, den Kompressor zunächst bei einer niedrigen Geschwindigkeit zu betreiben. Die Geschwindigkeit ist also zunächst gedrosselt und kann nachdem die Vorrichtung "hochgefahren wurde schrittweise erhöht werden. Mit dieser Vorgehensweise werden plötzlich auftretende Stromverbrauchsspitzen vermieden.

Erfindungsgemäss weist die Klimatisierungsvorrichtung ein Wasserstoff- oder ein Gasniveau-Sensor auf, um im Falle einer Grenzwertüberschreitung bzgl. des vorhandenen Wasserstoffs bzw. anderer gasförmiger Stoffe den Modus Passivkühlung zu aktivieren. Nach Aktivierung des Modus wird die Drosselklappe in waagrechte Position gebracht, sodass zum einen die im Schaltschrank und im Klimatisierungsgehäuse befindliche Luft mitsamt den Schadstoffen nach Außen strömen kann und frische Umgebungsluft in die Klimatisierungsvorrichtung gelangen kann.

Eine weitere Ausgestaltungsform der vorliegenden Erfindung sieht einen Feuer- oder Rauchsensor vor. Im Falle einer Feuer- oder Rauchentwicklung wird zunächst die Drosselklappe in senkrechte Position gebracht, sofern diese in einer waagrechten Position sein sollte. Somit wird verhindert, dass Frischluft eine Feuer- oder Rauchentwicklung möglicherweise noch beschleunigt. Zudem werden sämtliche Gebläse und Bauteile der Klimatisierungsvorrichtung außer Betrieb genommen, um das Feuer zu ersticken und eine Ausbreitung der Flammen bzw. des Rauches zu verhindern.

Die erfindungsgemäße Klimatisierungsvorrichtung ist so aufgebaut, dass eine Inbetriebnahme mehrerer zusammenhängender Klimatisierungsvorrichtungen möglich ist. Bei einer Verwendung mehrere Vorrichtungen stellt eine Klimatisierungsvorrichtung die Master-Klimatisierungsvorrichtung dar, welchen den Betriebsmodus der verbleibenden Slave-Klimatisierungsvorrichtungen festlegt. Die Erfindung soll nachstehend anhand mehrerer Ausführungsbeispiele sowie unter Zuhilfenahme von Figuren näher erläutert werden.

Dabei zeigen:
- Fig. 1: eine räumliche Darstellung der erfindungsgemäßen Klimatisierungsvorrichtung;
- Fig. 2: eine Darstellung der Klimatisierungsvorrichtung mit geschlossener Drosselklappe und
- Fig. 3: eine Darstellung der Klimatisierungsvorrichtung mit geöffneter Drosselklappe.

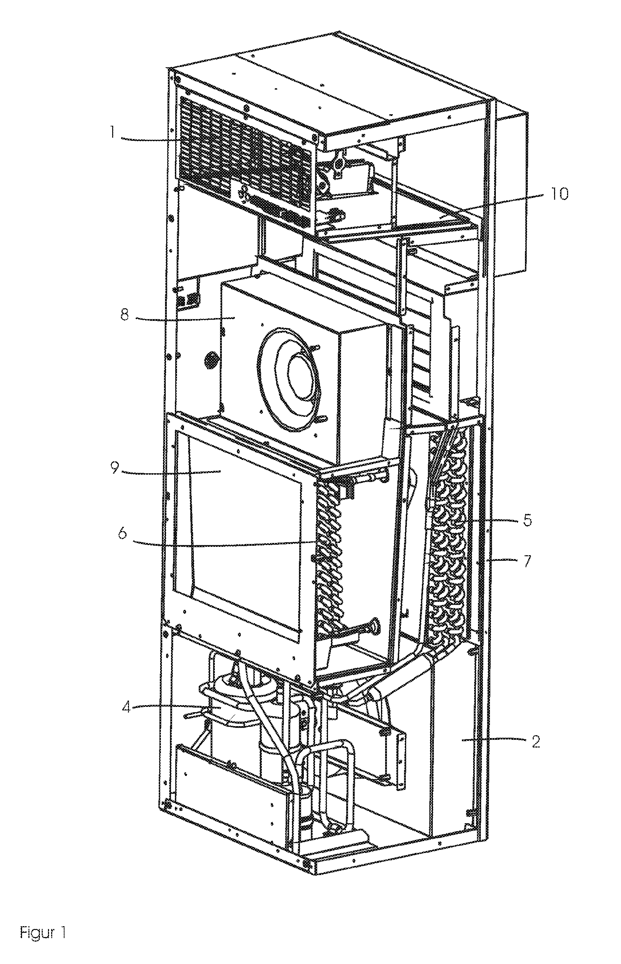

Wie in Fig. 1 dargestellt, befindet sich die Klimatisierungsvorrichtung in einem Gehäuse, welches zwei Öffnungen auf der zum Schaltschrank zugewandten Seite aufweist. Dadurch kann ein zirkulierender Luftstrom entstehen, welcher zwischen dem zu klimatisierenden Schaltschrank und der Klimatisierungsanlage hin- und hertransportiert wird.

Die zu kühlende oder zu erwärmende Luft tritt zunächst durch eine Öffnung 1 im oberen Bereich des Klimatisierungsgehäuses ein. Zugleich wird die zur Kompressorkühlung benötigte Kühlluft von einem wechselstromgespeistem Gebläse 2 im unteren Bereich auf der von dem Schaltschrank abweisenden Seite durch eine Kühllufteinlassöffnung 3 in das Gehäuse der Klimatisierungsvorrichtung transportiert.

Die Kühllufteinlassungsöffnung ist hierbei mit einem Metallmaschenfilter versehen, um in der Kühlluft enthaltene Staubpartikel zu Filtern.

Im drehzahlvariablen Kompressor 4 wird das gasförmige Kältemittel durch die Verdichtung zunächst sehr stark erhitzt. Das gasförmige Kältemittel wird zum Kondensator 5 transportiert, wo die aufgenommene Kompressionswärme im Kondensator 5 an die Umgebung abgegeben wird.

Das Kältemittel verlässt den Kondensator 5 im flüssigen Aggregatszustand und wird in Richtung des Verdampfers 6 transportiert. Die abgegebene Kompressionswärme und Energiewärme verlässt durch eine Öffnung 7 oberhalb der Kühlluftöffnung 3 das Klimatisierungsgehäuse.

Die vom Schaltschrank in das Gehäuse der Klimatisierungsvorrichtung transportierte Luft wird mittels eines gleichstromgespeisten Gebläses 8 zum Verdampfer 6 transportiert. Dort verdampft das vom Kondensator 5 kommende flüssige Kältemittel unter den gegebenen Verhältnissen, wobei der Verdampfer 6 der vom Schaltschrank kommenden Luft Wärme entzieht, und somit die Luft abkühlt.

Die abgekühlte Luft wird nach diesem Vorgang durch eine Öffnung 9 auf der zum Schaltschrank weisenden Seite in den Schaltschrank transportiert. Dieser dargestellte Kreislauf wiederholt sich anschließend.

Das Gebläse 2 ist in dieser Ausführungsform als ein drehzahlgeregeltes Gebläse ausgebildet. Das Gebläse 2 wird dabei derart geregelt, dass eine konstante Temperaturdifferenz zwischen der Umgebungstemperatur und der Kondensierungstemperatur erreicht wird. Dies führt zu einem verringerten Kondensationsdruck und folglich zu einem geringeren Stromverbrauch des drehzahlvariablen Kompressors 4.

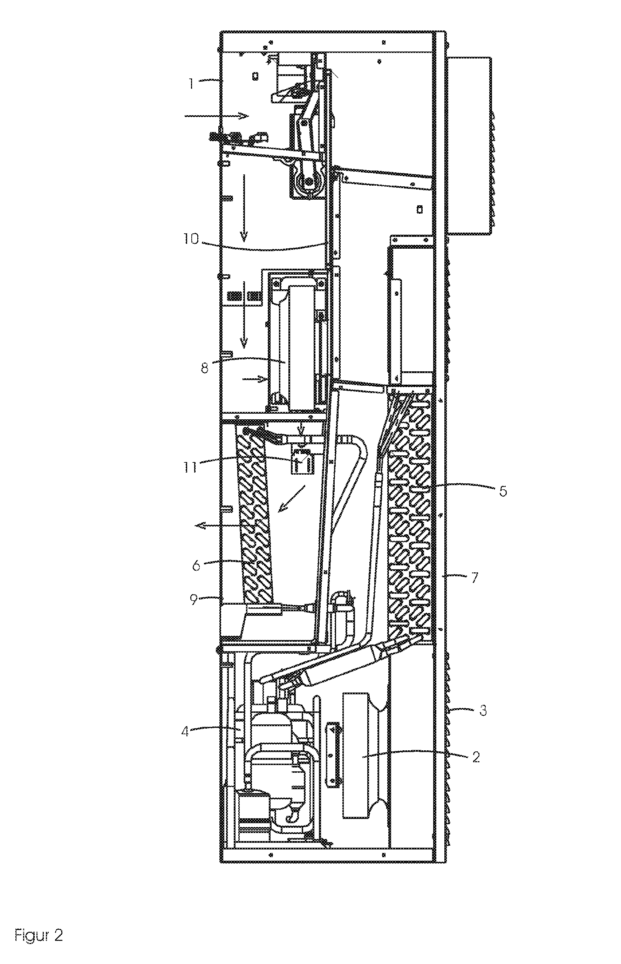

In Fig. 2 wird die erfindungsgemäße Klimatisierungsvorrichtung bei geschlossener Drosselklappe 10 dargestellt. Die Drosselklappe 10 ist während der Modi Aktivkühlung und Erwärmung geschlossen. Die in Fig. 2 dargestellten Pfeile geben die Luftströmung während des Modus Erwärmung an. Die Luft strömt durch die Gehäuseöffnung 1 in die Klimatisierungsvorrichtung und wird mittels des Gebläses 8 in Richtung des Verdampfers 6 transportiert. In diesem Bereich befindet sich ein Heizgerät 11, welches die durchströmende Luft erwärmt. Die erwärmte Luft verlässt durch die Gehäuseöffnung 9 die Klimatisierungsvorrichtung und wird zurück in den Schaltschrank transportiert.

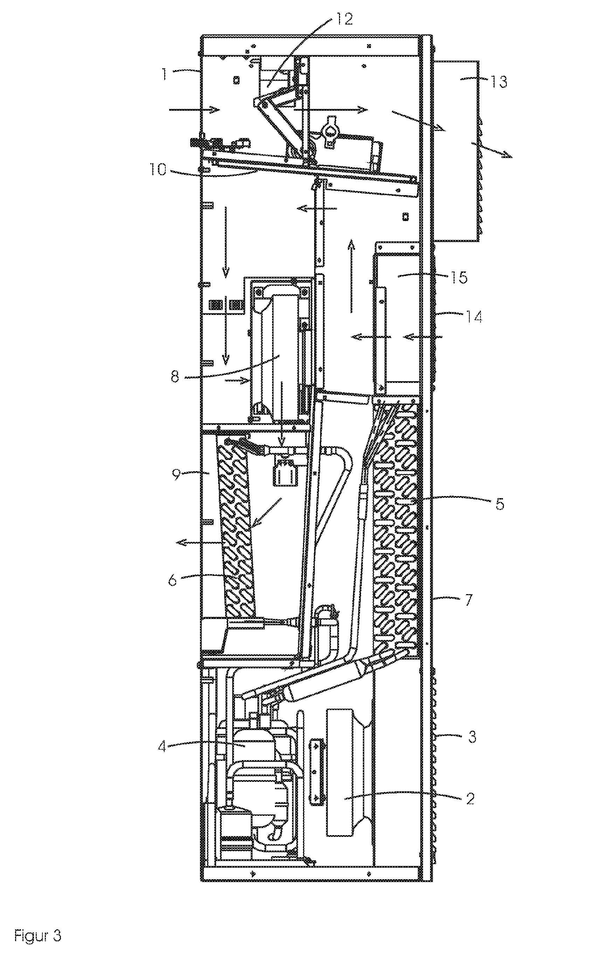

In Fig. 3 wird die Klimatisierungsvorrichtung mit geöffneter Drosselklappe 10 dargestellt. Die Drosselklappe 10 nimmt diese Position z. B. bei dem Betriebsmodus Passivkühlung oder eventuell auftretenden Störungen ein. Die Drosselklappe 10 wird von einem Motor 12 angetrieben. Die dargestellten Pfeile stellen die Luftströmung während des Betriebsmodus Passivkühlung dar. Die aus dem Schaltschrank strömende Luft wird zunächst über die Gehäuseöffnung 1 in die Klimatisierungsvorrichtung transportiert. Aufgrund der waagrechten Stellung der Drosselklappe 10 wird der Weg zum Gebläse 8 versperrt, sodass die Luft in Richtung der Gehäuseöffnung 13 strömt und dort aus der Klimatisierungsvorrichtung hinausströmt.

Zeitgleich fließt kühle Umgebungsluft durch eine Kühllufteinlassöffnung 14 auf der vom Schaltschrank abgewandten Seite des Klimatisierungsgehäuses in die Vorrichtung, wobei die Umgebungsluft zunächst einen HEPA-Filter 15 passieren muss. Die gereinigte Luft strömt anschließend in eine Kammer und von dort in Richtung des bekannten Gebläses 8.

Durch die Gehäuseöffnung 9 der Klimatisierungsvorrichtung wird die kühle und gefilterte Umgebungsluft in den Schaltschrank abgegeben.

### Bezugszeichenliste

- 1: Gehäuseöffnung
- 2: Gebläse
- 3: Kühllufteinlassöffnung
- 4: drehzahlvariabler Kompressor
- 5: Kondensator
- 6: Verdampfer
- 7: Gehäuseöffnung zur Abgabe der Kompressionswärme
- 8: Gebläse
- 9: Gehäuseöffnung zur Abgabe der klimatisierten Luft
- 10: Drosselklappe
- 11: Heizgerät
- 12: Drosselklappenmotor
- 13: Gehäuseöffnung zur Abgabe der aus dem Schaltschrank transportierten Luft
- 14: Kühllufteinlassöffnung
- 15: HEPA-Filter

## Patentansprüche

1. Klimatisierungsvorrichtung für Schaltschränke, wobei die in einem Gehäuse platzierte Klimatisierungsvorrichtung in baulicher Nähe zu einem Schaltschrank angebracht ist und mittels zum Schaltschrank weisenden Öffnungen eine Luftzirkulation zwischen dem Schaltschrank und der Klimatisierungsvorrichtung ermöglicht wird, wobei die Klimatisierungsvorrichtung in drei verschiedenen Modi betreibbar ist, welche
- eine Aktivkühlung, bei der der Schaltschrank durch eine Kompressionskühlung unter zu Hilfenahme eines drehzahlgeregelten Kompressors (4), eines Kondensators (5) und eines Verdampfers (6) realisiert wird,
- eine Passivkühlung bei der der Schaltschrank mit Umgebungsluft gekühlt wird und
- eine Erwärmung der im Schaltschrank zirkulierenden Luft ermöglichen, wobei die Klimatisierungsvorrichtung über ein Notstromsystem verfügt, welches in Form von Batterien bereitgestellt wird, wobei die Klimatisierungsvorrichtung einen Wasserstoff- oder einen Gasniveausensor umfasst, der im Falle einer Grenzwertüberschreitung den Modus Passivkühlung aktiviert, wobei eine mit einem gleichstromgespeisten Motor (12) angetriebene Drosselklappe (10) aktiviert wird und diese eine Stellung einnimmt, sodass eine direkte Kühlung des Schaltschrankes mit der Umgebungsluft erreicht wird.

2. Klimatisierungsvorrichtung nach Anspruch 1,
**dadurch gekennzeichnet, dass**
die benötigte Verdampfer-Luftströmung durch ein gleichstromgespeistes Gebläse (8) erzeugt wird.

3. Klimatisierungsvorrichtung nach einem der vorangegangenen Ansprüche,
**dadurch gekennzeichnet, dass**
beim Erwärmungsmodus, der in der Klimatisierungsvorrichtung befindliche Luftstrom von einem wechselstromgespeistem Heizgerät (11) erwärmt wird und durch eine zum Schaltschrank weisende Öffnung (9) zum Schaltschrank transportiert wird.

4. Klimatisierungsvorrichtung nach Anspruch 3,
**dadurch gekennzeichnet, dass**
der Luftstrom durch ein gleichstromgespeistes Gebläse (8) erzeugt wird.

5. Klimatisierungsvorrichtung nach einem der Ansprüche 1 bis 4,
**dadurch gekennzeichnet, dass**
die Drosselklappe (10) bei den Modi Aktivkühlung und Erwärmung eine Sperrstellung einnimmt, sodass keine unbehandelte Umgebungsluft in die Klimatisierungsvorrichtung gelangt.

6. Klimatisierungsvorrichtung nach einem der vorangegangenen Ansprüche,
**dadurch gekennzeichnet, dass**
in der Klimatisierungsvorrichtung ein Feuer- oder Rauchsensor vorgesehen ist, um im Falle einer Feuer oder Rauchentwicklung die Drosselklappe (10) zu schließen und sämtliche Gebläse und Bauteile auszuschalten.

7. Klimatisierungsvorrichtung nach einem der vorangegangenen Ansprüche,
**dadurch gekennzeichnet, dass**
die Klimatisierungsvorrichtung ein Alarmsystem aufweist, welches bei zu hohen oder zu niedrigen Betriebstemperaturen, bei Ausfall von Bauteilen, der Stromversorgung oder der Heizfunktion ein Warnsignal ausgibt.

8. Verwendung mehrere Klimatisierungsvorrichtungen nach einem der Ansprüche 1 bis 7,
**dadurch gekennzeichnet, dass**
eine der Klimatisierungsvorrichtungen als Master-Klimatisierungsvorrichtung fungiert und den Betriebsmodus der Slave-Klimatisierungsvorrichtungen festsetzt.

## Claims

1. Air-conditioning device for control cabinets, wherein the air-conditioning device being placed in a housing is mounted in structural proximity to a control cabinet, and an air circulation is enabled between the control cabinet and the air-conditioning device by means of openings oriented toward the control cabinet,
wherein the air-conditioning device can be operated in three different modes enabling
- active cooling, in which the control cabinet's cooling is realized by compression cooling with the help of a speed-controlled compressor (4), a condenser (5) and an evaporator (6),
- passive cooling, in which the control cabinet is cooled with ambient air, and
- heating of the air circulating within the control cabinet,
wherein the air-conditioning device has an emergency power system provided in the form of batteries, wherein the air-conditioning device comprises a hydrogen or gas level sensor which activates the passive cooling mode in the event of a threshold being exceeded,
wherein a throttle valve (10) driven by means of a DC-powered motor (12) is activated and adopts a position such that direct cooling of the control cabinet by ambient air is achieved.

2. Air-conditioning device according to claim 1,
**characterized in that**
the required evaporator air flow is generated by a DC-powered fan (8).

3. Air-conditioning device according to any one of the preceding claims,
**characterized in that**
in the heating mode, the air flow present within the air-conditioning device is heated by an AC-powered heating device (11) and is conveyed to the control cabinet through an opening (9) oriented toward the control cabinet.

4. Air-conditioning device according to claim 3,
**characterized in that**
the air flow is generated by a DC-powered fan (8).

5. Air-conditioning device according to any one of claims 1 to 4,
**characterized in that**
the throttle valve (10), in the active cooling and heating modes, adopts a blocking position such that untreated ambient air does not reach the air-conditioning device.

6. Air-conditioning device according to any one of the preceding claims,
**characterized in that**
a fire or smoke sensor is provided in the air-conditioning device for closing the throttle valve (10) and cutting off the entirety of fans and components in the event of fire or smoke emission.

7. Air-conditioning device according to any one of the preceding claims,
**characterized in that**
the air-conditioning device comprises an alarm system which outputs a warning signal when operating temperatures are too high or too low, when components, the power supply or the heating function fail.

8. Use of a plurality of air-conditioning devices according to any one of claims 1 to 7,
**characterized in that**
one of the air-conditioning devices functions as a master air-conditioning device and defines the operating mode of the slave air-conditioning devices.

## Revendications

1. Dispositif de climatisation pour armoires de commutation, dans lequel le dispositif de climatisation placé dans un boîtier est monté à proximité structurelle d'une armoire de commutation et permet, au moyen d'ouvertures tournées vers l'armoire de commutation, une circulation d'air entre l'armoire de commutation et le dispositif de climatisation, dans lequel le dispositif de climatisation est susceptible de fonctionner dans trois modes différentes qui permettent
- un refroidissement actif dans lequel l'armoire de commutation est soumise à un refroidissement par compression avec l'aide d'un compresseur à vitesse de rotation régulée (4), d'un condenseur (5) et d'un évaporateur (6),
- un refroidissement passif dans lequel l'armoire de commutation est refroidie avec de l'air environnant, et
- un chauffage de l'air circulant dans l'armoire de commutation,
dans lequel le dispositif de climatisation dispose d'un système d'alimentation électrique de secours, réalisé sous la forme de batteries, et dans lequel le dispositif de climatisation inclut un capteur de niveau d'hydrogène ou un capteur de niveau de gaz qui active le mode de refroidissement passif dans le cas d'un dépassement d'une valeur limite,
dans lequel un volet d'étranglement (10) entraîné par un moteur (12) alimenté en courant continu est activé et celui-ci occupe une position telle qu'un refroidissement direct de l'armoire de commutation avec l'air environnant est atteint.

2. Dispositif de climatisation selon la revendication 1,
**caractérisé en ce que** le courant d'air nécessaire pour l'évaporateur est engendré par une ventilateur (8) alimenté en courant continu.

3. Dispositif de climatisation selon l'une des revendications précédentes,
**caractérisé en ce que** dans le mode de chauffage, le courant d'air qui se trouve dans le dispositif de climatisation est chauffé par un appareil de chauffe (11) alimenté en courant alternatif, et est transporté vers l'armoire de commutation à travers une ouverture (9) tournée vers l'armoire de commutation.

4. Dispositif de climatisation selon la revendication 3,
**caractérisé en ce que** le courant d'air est engendré par un ventilateur (8) alimenté en courant continu.

5. Dispositif de climatisation selon l'une des revendications 1 à 4,
**caractérisé en ce que** le volet d'étranglement (10) occupe, dans le mode de refroidissement actif et dans le mode de chauffage, une position de blocage, de sorte qu'aucun air environnant non traité ne parvient dans le dispositif de climatisation.

6. Dispositif de climatisation selon l'une des revendications précédentes,
**caractérisé en ce qu'**un détecteur d'incendie ou de fumées est prévu dans le dispositif de climatisation, afin de fermer le volet d'étranglement (10) est d'arrêter la totalité des ventilateurs et autres composants dans le cas d'un incendie ou d'un développement de fumées.

7. Dispositif de climatisation selon l'une des revendications précédentes,
**caractérisé en ce que** le dispositif de climatisation comprend un système d'alarme qui délivre un signal d'avertissement dans le cas de températures de service trop élevées ou trop faibles, en cas de défaillance de composants, de l'alimentation électrique ou de la fonction de chauffage.

8. Utilisation de plusieurs dispositifs de climatisation selon l'une des revendications 1 à 7,
**caractérisé en ce que** l'un des dispositifs de climatisation fait office de dispositif de climatisation maître et impose le mode de fonctionnement des dispositifs de climatisation esclaves.
